# EUROPÄISCHE PATENTSCHRIFT

(11) **EP 1 363 362 B1**
(45) Veröffentlichungstag und Bekanntmachung des Hinweises auf die Patenterteilung: **29.06.2005**
(21) Anmeldenummer: 03006513.0
(22) Anmeldetag: 22.03.2003
(51) Int. Cl.: H01R 13/02

(54) **Umformen von Leiterenden eines Flachbandkabels**
Processing of wire ends of a flat cable
Formage des fils électriques d'un câble plat

(30) Priorität: 16.05.2002 DE 10221702; 15.01.2003 DE 10301227
(43) Veröffentlichungstag der Anmeldung: 19.11.2003
(73) Patentinhaber: Hirschmann Automotive GmbH, 6830 Rankweil-Brederis (AT)
(72) Erfinder: Feder, Roland, 6820 Gurtis (AT); Reiss, Thomas, 6830 Rankweil (AT); Kreuter, Markus, 6895 Hohenems (AT); Peter, Gerhard, 6832 Sulz (AT)
(74) Vertreter: Thul, Hermann, Dipl.-Phys.

(56) Entgegenhaltungen:
- DE-B- 1 135 541
- DE-C- 4 013 620

## Beschreibung

Die Erfindung betrifft ein Flachbandkabel mit einem elektrischen Leiter oder mehreren parallel zueinander verlaufenden elektrischen Leitern gemäß den Merkmalen des Patentanspruches 1.

Flachbandkabel, bei denen innerhalb eines Isoliermantels mehrere elektrische Leiter zueinander parallel verlaufen, sind bekannt. Hierbei handelt es sich insbesondere um Meterware, die nach dem entsprechenden Abschneiden noch mit Kontaktpartnern versehen werden muß. Über das Flachbandkabel mit den Kontaktpartnern werden beispielsweise Sensoren, Aktuatoren, Steuereinheiten und dergleichen, insbesondere für Anwendungen bei Fahrzeugen, miteinander verbunden. Bei diesem Anwendungsgebiet sind die Erfordernisse an die Zuverlässigkeit (wie Kontaktsicherheit und Langlebigkeit) an die Kontaktierung sehr hoch, denn diese Kontaktierung ist oftmals äußeren Einflüssen wie Temperaturschwankungen, Vibrationen, Feuchtigkeit und dergleichen ausgesetzt.

Daher hat es schon viele Bemühungen gegeben, diese Kontaktierung den Erfordernissen anzupassen. Dabei existiert die Schwierigkeit, daß die elektrischen Leiter aus flachem Kupfermaterial bestehen, welches einerseits nach dem Freilegen vor der Kontaktierung durch Korrosion eine Oxidschicht bilden kann, welches die Kontaktierung erschwert. Dem könnte durch Beschichtungen, wie beispielsweise Verzinnen, begegnet werden, wodurch jedoch der Arbeitsaufwand zur Herstellung der Kontaktierung vergrößert wird. Außerdem eignet sich der Querschnitt der flachen elektrischen Leiter nicht für alle Arten der erforderlichen Kontaktierung, insbesondere nicht für runde Öffnungen (Bohrungen) in Leiterplatten.

Aus der DE-C-40 13 620 ist ein Flachleiterverbinder sowie ein Verfahren zu dessen Herstellung bekannt. Dieser Flachleiterverbinder weist ein Flachbandkabel mit mehreren parallel zueinander verlaufenden elektrischen Leitern auf, wobei die Leiterenden der elektrischen Leiter als hohlzylinderförmige Stifte ausgebildet sind, die durch Rundbiegen der freien Enden der flachen Leiterbahnen gebildet worden sind. Das derart ausgebildete Ende des Flachbandkabels wird mit Kunststoff umspritzt, um einen Steckerkörper zu bilden. Die hohlzylinderförmigen Stifte sind Kontaktpartner, die mit Gegenkontaktpartnern (Buchsen) eines Gegenstücks des Flachleiterverbinders lösbar verbunden werden können, um somit durch den Flachleiterverbinder (Stecker) und einen weiteren korrespondierenden Flachleiterverbinder (Buchse) eine lösbare Steckverbindung zu realisieren.

Der Erfindung liegt daher die Aufgabe zugrunde, ein Flachbandkabel zwecks Kontaktierung über seine Leiterenden bereitzustellen, mit dem die eingangs geschilderten Nachteile vermieden werden.

Diese Aufgabe ist durch die Merkmale des Patentanspruches 1 gelöst.

Erfindungsgemäß ist vorgesehen, daß das Leiterende vor der Kontaktierung in eine der Form des Kontaktierungsbereiches des Kontaktpartners entsprechende Form umgeformt ist. Dies wirkt sich zunächst bei der Herstellung des Kabelsatzes positiv aus. Denn bei der Verwendung von Meterware kann das Flachbandkabel auf die gewünschte Länge gebracht werden und anschließend die Leiterenden für die weitere Kontaktierung freigelegt werden. Da anschließend eine Umformung der freigelegten Leiterenden stattfindet, spielt eine Oxidschicht auf den Leiterenden, die sich gegebenenfalls bei längerer Lagerhaltung bilden kann, keine Rolle, da diese bei der Umformung aufgebrochen wird und somit für die darauffolgende Kontaktierung nicht mehr hinderlich ist. Auch bei der Kontaktierung selber wirkt es sich positiv aus, daß die Form des Leiterendes nach dem Umformen weitestgehend der Form des Kontaktpartners entspricht, so daß eine wesentlich erhöhte Anlagefläche zwischen umgeformtem Leiterende und Kontaktpartner zur Verfügung steht. Dadurch ist eine wesentlich zuverlässigere Kontaktierung sowohl bei einer Formpassung als auch bei einer materialschlüssigen Verbindung (wie beispielsweise Löten oder Schweißen) gegeben. Bei einer Formpassung hat die Umformung darüber hinaus noch den Vorteil, daß je nach Formgebung des Leiterendes eine Federwirkung dieses Kontaktbereiches gegeben ist, die zusätzlich die Kontaktsicherheit verbessert. Somit kann aus dem an sich biegeschlaffen und blanken, aber auch oberflächenbehandelten Leiterende des elektrischen Leiters ein stabiler Direktkontakt geformt werden, der zur direkten und präzisen Positionierung und Kontaktierung auf bzw. mit verschiedensten Kontaktpartnern dienen kann. Durch diese Umformung werden darüber hinaus Fertigungstoleranzen des Flachbandkabels, insbesondere seiner elektrischen Leiter, ausgeglichen. Dadurch sind Abstand, Parallelität und Einsatztiefe in bzw. auf bzw. an dem Kontaktpartner gewährleistet. Außerdem sind durch die vergrößerten Anlageflächen die elektrischen Leiter und insgesamt die Kontaktierung höher strombelastbar. Darüber hinaus kann eine Zugentlastung aufgrund der höheren mechanischen Festigkeit entfallen. Es lassen sich also beliebige unlösbare Kontaktierungen (Verbindungen zwischen Leiterende und Kontaktpartner) realisieren.

Das zu einem derartigen Direktkontakt geformte Leiterende kann direkt und präzise mit verschiedenen Kontaktpartnern verbunden werden, um eine unlösbare Verbindung herzustellen. Bei unlösbaren Verbindungen handelt es sich beispielsweise um Löten (wie Hand-, Schwallbad-, Flamm-, Induktions- oder Widerstandspreßlöten), das gleichzeitig den Vorteil der Durchkontaktierung (auf Leiterplatten oder MID) hat. Außerdem sind beim Verlöten der Kontaktierung auch andere Bauteile, wie beispielsweise elektronische Bauteile oder Brücken oder dergleichen, mit verlötbar. Beim Schweißen kommen beispielsweise Punkt-, Laser- oder Induktionsschweißen in Betracht, wobei auch hier wieder elektrische Bauteile, Drahtbrücken oder dergleichen im gleichen Arbeitsgang mit geschweißt werden können. Weiterhin kommt zwecks Kontaktierung ein Crimp-Vorgang in Betracht, wobei das freigelegte und damit blanke oder auch vorher oberflächenbehandelte Leiterende auf die jeweils erforderliche Geometrie des anzubringenden Crimp-Kontaktes umgeformt und danach direkt aufgecrimpt wird. Dadurch entsteht noch der zusätzliche Vorteil, daß aufgrund der Lagefixierung der elektrischen Leiter in dem Isoliermantel auch die Crimpkontakte nach dem Crimpen präzise zueinander wegen der Spurtreue ausgerichtet sind.

Verschiedene Ausführungsbeispiele der Erfindung, auf die diese jedoch nicht beschränkt ist, sind im folgenden erläutert und anhand der Figuren beschrieben.

Es zeigen:
- Figur 1:: ein Flachbandkabel,
- Figur 2:: das Flachbandkabel mit umgeformten Leiterenden,
- Figur 3:: verschiedene Umformungsmöglichkeiten,
- Figur 4 und 5:: verschiedene Kontaktierungen von umgeformten Leiterenden,
- Figur 6:: Leiterende, unterteilt in mehrere Teilabschnitte zur Umformung,
- Figur 7: zwei verschieden breite Leiterenden, die miteinander vercrimpt werden.

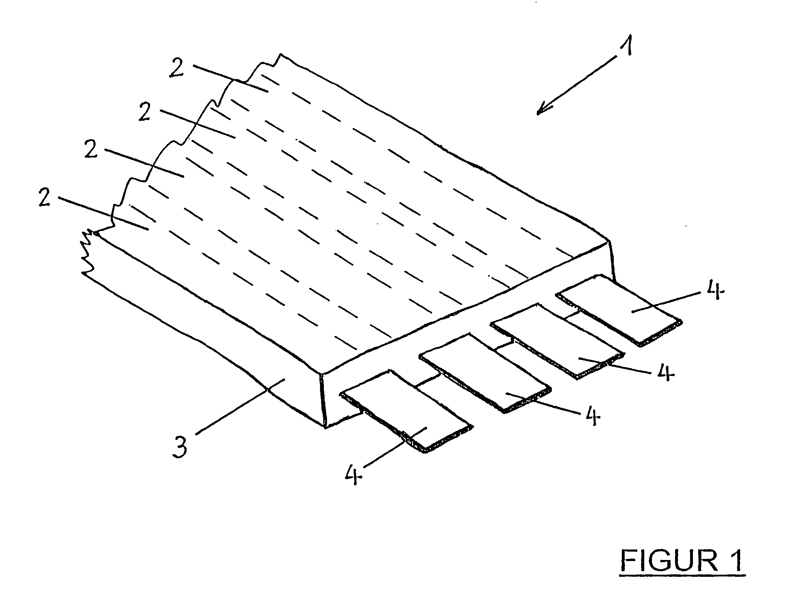

Figur 1 zeigt ein an sich bekanntes Flachbandkabel 1, bei dem es sich auch um eine flexible Leiterplatte (wie beispielsweise FFC oder FPC) handeln kann. Bei diesem Flachbandkabel 1 verlaufen parallel zueinander mehrere elektrische Leiter 2, bei denen es sich beispielsweise um flache Kupferbahnen handelt. Diese elektrischen Leiter 2 sind innerhalb eines aus nicht leitfähigem Material (insbesondere Kunststoff) bestehenden Isoliermantel 3 festgelegt. Dieser Isoliermantel 3 kann auch nur aus einer Trägerschicht für die elektrischen Leiter 2 bestehen. Das Flachbandkabel 1 wird zwecks Kontaktierung so vorbereitet, daß auf geeignete Art und Weise, auf die es hier nicht ankommt, die elektrischen Leiter 2 an ihren Leiterenden 4 gleich lang oder mit verschiedenen Längen freigelegt werden. An dieser Stelle sei noch einmal erwähnt, daß die freigelegten Leiterenden 4, gerade wenn sie aus Kupfer bestehen, sehr schnelle korrodieren können, was die nachfolgende Kontaktierung behindert. Außerdem ist die Form der in Figur 1 gezeigten Leiterenden 4 für eine zuverlässige Kontaktierung nicht brauchbar.

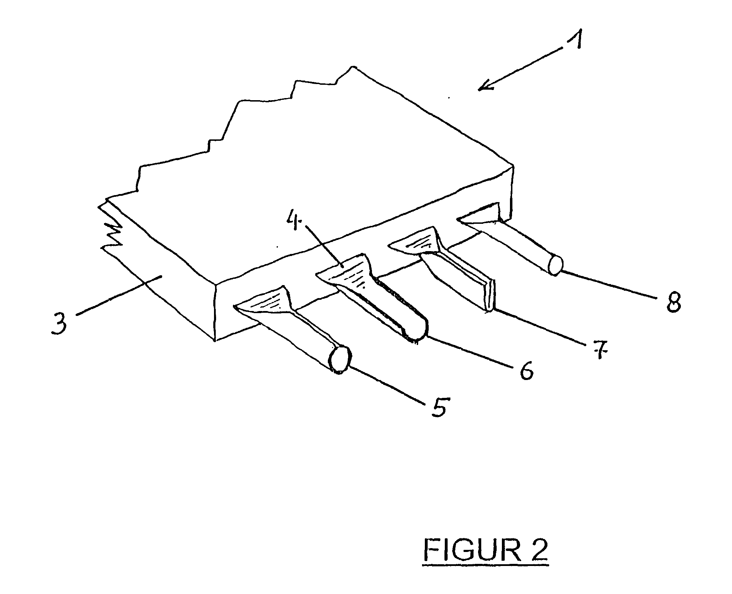

Figur 2 zeigt daher, daß die Leiterenden 4 vor der Kontaktierung in eine der Form des Kontaktierungsbereiches des jeweiligen Kontaktpartners entsprechende Form umgeformt sind. Hierbei sind mehrere Formen beispielhaft gezeigt, wobei bei ein und demselben Flachbandkabel 1 durchgehend für alle Leiterenden 4 die gleiche Umformung erfolgen kann. Dabei ist es aber auch denkbar, jedem einzelnen Leiterende eine bestimmte Form oder auch bestimmten Leiterenden gruppenweise bestimmte Formen zu geben. Als beispielhafte Formen sind in Figur 2 gezeigt eine offene Rundform 5, bei der die Anlageflächen nicht materialschlüssig miteinander verbunden werden. Dadurch entsteht eine gewisse Nachgiebigkeit dieser offenen Rundform 5, die aufgrund der dadurch zur Verfügung gestellten Federkraft für eine verbesserte Kontaktierung genutzt werden kann. Weiterhin ist eine Hohlkehlenform 6 gezeigt, die beispielsweise bei Feder- oder Crimpkontakten zur Anwendung kommen kann. Zwecks Erhöhung des Querschnittes ist eine gefaltete Form 7 gezeigt, während mit der Bezugsziffer 8 eine geschlossene Rundform gezeigt ist, bei der die Anlageflächen materialschlüssig (zum Beispiel durch Verlöten oder Verschweißen) miteinander verbunden sind. Dadurch entsteht ein in sich stabiler Kontaktierungsbereich, der beispielsweise für einen entsprechenden Federkontakt genutzt werden kann.

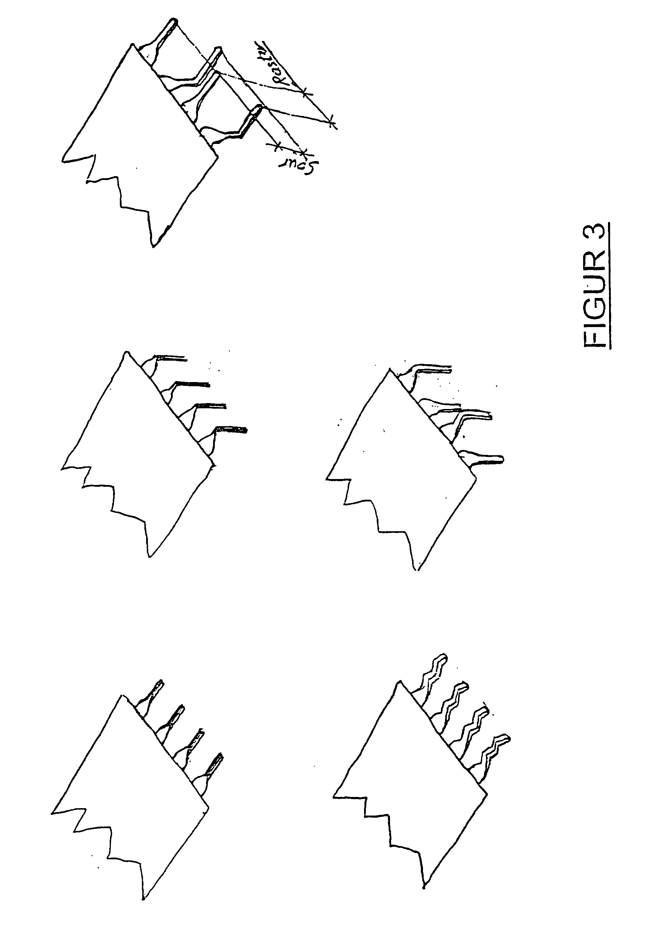

Figur 3 zeigt verschiedene Flachbandkabel mit unterschiedlich umgeformten Leiterenden, wobei die Leiterenden gerade, abgewinkelt, gewellt, gezackt bzw. einer Spur und einem Raster folgend umgeformt worden sind. Diese Spur- und Rastertreue hat insbesondere dann den Vorteil, wenn dieses Ende des Flachbandkabels mit einer Leiterplatte oder dergleichen verbunden werden soll. Denn durch diese Treue entfallen Halte- und Positioniervorrichtungen, wenn die freigelegten und umgeformten Leiterenden in die entsprechenden Kontaktpartner der Leiterplatte eingeführt werden sollen.

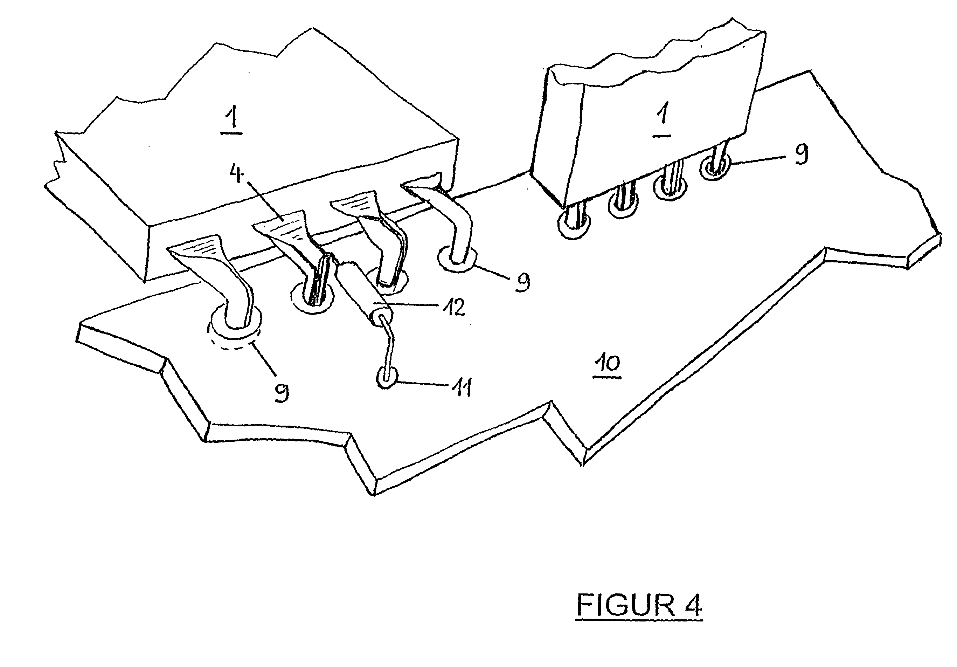

Figur 4 zeigt ein besonders wesentliches und vorteilhaftes Ausführungsbeispiel mit mehreren Kontaktstellen 9 innerhalb einer Leiterplatte 10, bei der es sich auch um ein MID, Stanzgitter oder dergleichen handeln kann. Nach dem Umformen der Leiterenden 4 können diese in die Kontaktstellen 9 eingeführt werden, wobei beispielhaft gezeigt ist, daß das zu kontaktierende Flachbandkabel 1 senkrecht oder parallel zu der Leiterplatte 10 angeordnet ist. Je nach Art der Umformung lassen sich auch andere Winkel zwischen Flachbandkabel 1 und Leiterplatte 10 vorgeben. Nach dem Einführen der umgeformten Leiterenden 4 in die Kontaktstellen 9 kann eine materialschlüssige Verbindung, insbesondere durch Löten oder Schweißen, erfolgen. Ergänzend ist noch gezeigt, daß die Leiterplatte 10 zumindest eine weitere Kontaktstelle 11 aufweist, wobei zwischen der Kontaktstelle 11 und einem Leiterende 4 ein elektronisches Bauteil, eine Drahtbrücke oder dergleichen eingefügt werden kann. Hier zeigt sich der besondere Vorteil der Hohlkehlenform des umgeformten Leiterendes 4, da einerseits die Kontaktfläche zur Kontaktstelle 9 deutlich vergrößert ist, andererseits aber auch Platz zur Verfügung steht, um eine Kontaktierung mit dem Bauteil 12 zu ermöglichen.

In diesem besonders wesentlichen Ausführungsbeispiel ist deutlich zu erkennen, daß bei Ausführung der Kontaktstellen 9 als runde Bohrung in der Leiterplatte 10 durch das Umformen der Leiterenden 4 in eine Rundform 5 oder 8 überhaupt erst eine Kontaktierung ermöglicht wird, denn das an sich flache Leiterende 4 würde entweder aufgrund des zu geringen Durchmessers überhaupt nicht in die Kontaktstelle 9 hineinpassen oder aber einen wesentlich größeren Durchmesser der Kontaktstelle 9 erfordern, der der Längserstreckung des nicht umgeformten Leiterendes 4 entsprechen müßte. Dies ist aber aufgrund des häufig vorgegebenen Rastermaßes (zum Beispiel 2,54 mm) nicht möglich, da die elektrischen Leiter 2 eine entsprechende Höhe und Breite aufweisen müssen, um einen entsprechenden Stromfluß realisieren zu können. Daher ist es wichtig, das an sich flache Leiterende 4 in eine entsprechende Rundform, gegebenenfalls unter weiterer Umformung, wie sie beispielhaft in Figur 3 gezeigt sind, umzuformen und den Kontaktstellten 9 auf der Leiterplatte 10 anzupassen.

Bisher wurde davon ausgegangen, daß nach dem Umformen der Leiterenden 4 diese in die Kontaktstellen 9 eingeführt werden und eine Kontaktierung über eine materialschlüssige Verbindung erfolgt. Ergänzend oder alternativ dazu kann auch eine formschlüssige Kontaktierung, die nach Herstellung des Formschlusses unlösbar ist, realisiert werden. Dies kann beispielsweise dadurch erfolgen, daß nach dem Einführen des umgeformten Leiterendes 4 in die Kontaktstelle 9 ein Stift, ein Keil oder dergleichen in die Hohlkehle eingesetzt bzw. eingepreßt wird. Dieser Stift, Keil oder dergleichen kann aus einem elektrisch leitfähigen oder elektrisch isolierenden Material (beispielsweise einem Kunststoff) bestehen. Durch das Einführen, insbesondere Einpressen dieses Stiftes oder Keiles oder dergleichen wird das umgeformte Leiterende 4 im Bereich der Kontaktstelle 9 an diese gedrückt, wobei es insbesondere oberhalb oder unterhalb der Leiterplatte 10 zu Hinterschneidungen kommen kann, um die Kontaktfläche zu erhöhen. Dabei ist das Bauteil, welches in die Hohlkehlenform eingeführt wird, so gestaltet, daß eine unlösbare Kontaktierung (Verbindung zwischen dem Leiterende 4 und der Kontaktstelle 9) realisiert wird. Insbesondere bei der Anwendung solcher Flachbandkabel 1 bei Fahrzeugen bietet es sich an, eine unlösbare Kontaktierung herzustellen, da diese besonders widerstandsfähig ist gegenüber Temperaturschwankungen, Vibrationen und dergleichen, die im Betrieb des Fahrzeuges auftreten.

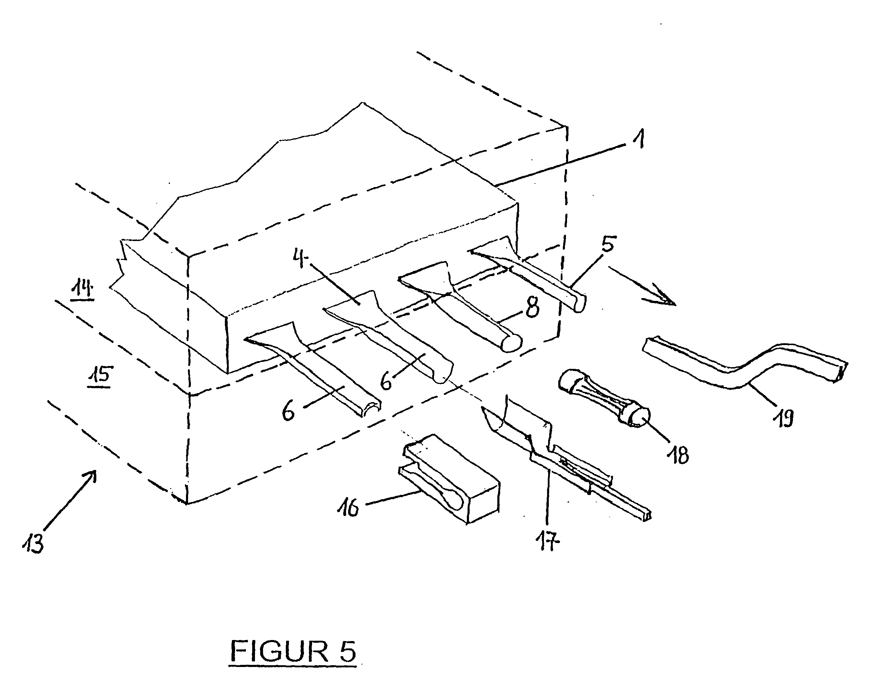

Figur 5 zeigt verschiedene Möglichkeiten einer lösbaren Kontaktierung, während in Figur 4 nach der Kontaktierung unlösbare Verbindungen gezeigt waren. Um mit dem Flachbandkabel 1 und seinen umgeformten Leiterenden 4 als Kontaktpartner beispielsweise einen Stecker (oder eine Buchse) realisieren zu können, ist im Bereich der Leiterenden 4 das Ende des Isoliermantels 3 des Flachbandkabels 1 in einem Gehäuse 13 eingesetzt. Dieses Gehäuse kann beispielsweise einteilig sein und einen Schlitz aufweisen, in welchem der Isoliermantel 3 eingeführt und lagefixiert wird. Anstelle dessen kann das Gehäuse 13 auch mehrteilig ausgestaltet sein und insbesondere ein Oberteil 14 und ein Unterteil 15 aufweisen, zwischen denen der Isoliermantel 3 des Flachbandkabels 1 festgelegt wird. Vor oder nach dem Einsetzen des Flachbandekabels 1 in das Gehäuse 13 werden die Leiterenden 4 in entsprechender Weise umgeformt, so daß auf jeden Fall nach dem Umgeben des Flachbandkabels 1 mit dem Gehäuse 13 ein Steckverbinder zur Verfügung steht. Ein solcher Steckverbinder kann beispielsweise ein Stecker oder eine Buchse oder beides sein. Beispielhaft ist hier erläutert, daß bei der Hohlkehlenform 6 ein Federkontakt 16 bzw. ein Crimpkontakt 17 zur Anwendung kommen kann. Bei Anwendung eines Federkontaktes 16 wird zwischen den Kontaktpartnern eine lösbare Verbindung hergestellt, während bei Anwendung des Crimpkontaktes 17 eine unlösbare Verbindung erzielt wird. Wurde das Leiterende 4 zu der geschlossenen Rundform 8 oder auch zu der offenen Rundform 5 umgeformt, kann ein Federkontakt 18 in dieses Rohrende zwecks Kontaktierung ein- und ausgeführt werden. Bei der offenen Rundform 5 (ebenso wie bei der Hohlkehlenform 6) kann ein Stiftkontakt 19 mit dem derart umgeformten Leiterende 4 verbunden werden.

Bei den bisherigen Beschreibungen, insbesondere bei den Erläuterungen zu den Ausführungsbeispielen gemäß den Figuren 1 bis 5 wurde davon ausgegangen, daß das Flachbandkabel 1 mehrere parallel zueinander verlaufende elektrische Leiter 2 aufweist. Die Verwendung dieser Ausführungsform bietet sich dann an, wenn über das Flachbandkabel 1 zum Beispiel mehrere Signale und eine Stromversorgung übertragen werden sollen. Soll beispielsweise nur eine Gleichstromversorgung (Plus und Masse) über das Flachbandkabel 1 erfolgen, reicht es aus, wenn zwei elektrische Leiter 2 vorhanden sind. Je nach Stromstärke, die übertragen werden soll, ist es auch denkbar, zwei oder mehrere elektrische Leiter 2 für ein und denselben Übertragungszweck zusammenzufassen. Ebenso kann auch eine Ausführungsform in Betracht kommen, bei der das Flachbandkabel 1 lediglich einen einzigen elektrischen Leiter 2 aufweist, der in dem Isoliermantel 3 eingebettet ist. Dabei weist der elektrische Leiter 2 eine größere Breite bzw. eine höhere Dicke auf als diejenigen elektrischen Leiter 2, die bei einem Flachbandkabel 1 vorhanden sind, das lediglich zur Signalübertragung eingesetzt wird.

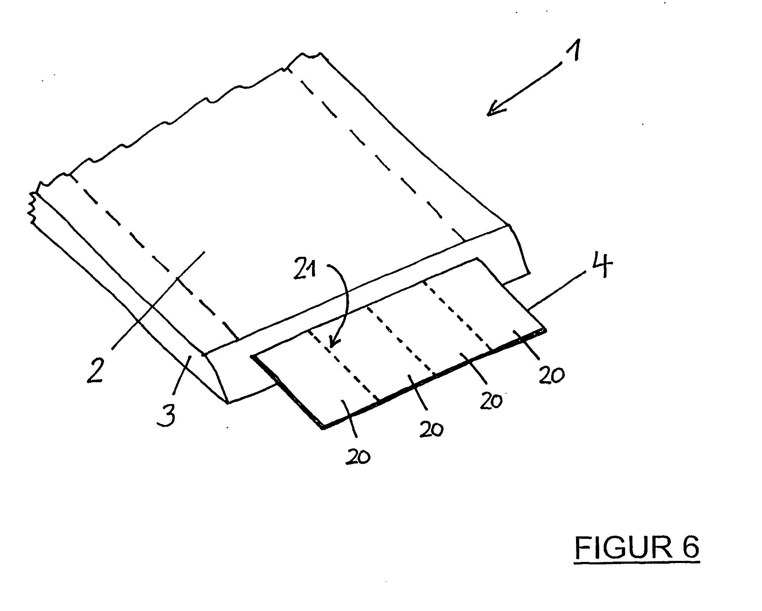

So zeigt beispielsweise Figur 6 das Flachbandkabel 1 mit einem elektrischen Leiter 2, der sich in etwa über die annähernd gesamte Breite des Flachbandkabels 1 erstreckt. Somit weist also der elektrische Leiter 2 gemäß Figur 6 eine größere Breite (und auch, wenn nicht direkt erkennbar, aber auch eine größere Dicke) als die elektrischen Leiter 2 gemäß Figur 1 auf. Während aufgrund der geometrischen Abmessungen der Leiterenden 4 gemäß Figur 1 es ohne weiteres möglich war, das Leiterende vor der Kontaktierung in eine der Form des Kontaktierungsbereiches des Kontaktpartners entsprechende Form umzuformen (s. Figur 2) ist dies aufgrund der geometrischen Abmessungen des Leiterendes 4 gemäß Figur 6 und bei gleichen Kontaktpartnern, die bei den geometrischen Ausführungen des Flachbandkabels 1 gemäß Figur 1 zur Anwendung kommen können (s. beispielsweise Figur 5, Bezugsziffern 16 bis 19) nicht möglich, diese Kontaktpartner bei den geometrischen Verhältnissen des Leiterendes 4 gemäß Figur 6 einzusetzen. Daher ist es hier von besonderem Vorteil und von wesentlicher Wichtigkeit, daß das jeweilige Leiterende 4 in wenigstens zwei Teilabschnitte 20 unterteilbar ist und jeder Teilabschnitt 20 vor der Kontaktierung in die der Form des Kontaktierungsbereiches des Kontaktpartners entsprechende Form umgeformt wird. Das bedeutet, daß das Leiterende 4 nach dem Entfernen des Isoliermantels 3 derart in mehrere Teilabschnitte 20 unterteilt wird, die beispielsweise den geometrischen Abmessungen der Leiterenden 4 gemäß Figur 1 entsprechen. Diese einzelnen Teilabschnitte 20 können dann genauso umgeformt werden, wie dies schon in Figur 2 gezeigt und dazu beschrieben ist. Ein Vorteil dieser Vorgehensweise besteht darin, daß Kontaktpartner mit bestimmten Abmessungen sowohl bei "schmalen" Leiterbahnen 2 (wie in Figur 1) oder auch bei "breiten" Leitern 2 (wie in Figur 6 gezeigt) eingesetzt werden können. Ein weiterer Vorteil besteht darin, daß an dem breiten Leiterende 4 gemäß Figur 6 mehrere gleichartige oder voneinander verschiedene Kontaktpartner angeordnet werden können, über die dann die Stromübertragung erfolgt. Dadurch wird es ermöglicht, daß an dem Ende des Flachbandkabels 1 eine Steckverbindung angeordnet werden kann (s. beispielsweise Figur 5), die mehrere Kontaktpartner aufweist, wobei über diese Kontaktpartner verschiedene und voneinander getrennte Signalpfade (s. Figur 1) oder ein einziger Signalpfad über mehrere Kontaktpartner (s. Figur 6) realisiert ist.

Die Aufteilung des Leiterendes 4 in mehrere Teilabschnitte 20 kann beispielsweise derart erfolgen, daß das Leiterende 4 in Längsrichtung entlang einer Trennlinie 21 in wenigstens zwei Teilabschnitte 20 geschlitzt wird. Nach diesem Schlitz- oder Trennvorgang können die Teilabschnitte 20 des Leiterendes 4 in die verschiedenen Formen umgeformt werden, wie sie beispielsweise in Figur 2 gezeigt und mit den Bezugsziffern 5 bis 8 versehen sind. Auch hierbei gilt wieder, daß die Umformung für alle Teilabschnitte 20 des Leiterendes 4 gleich oder unterschiedlich ist. Eine weitere Möglichkeit der Aufteilung des Leiterendes 4 in wenigstens zwei Teilabschnitte 20 besteht darin, daß die Unterteilung derart erfolgt, daß zwischen den Teilabschnitten 20 ein Freiraum entsteht. Das bedeutet, daß beispielsweise zwischen den Teilabschnitten 20, die stehenbleiben sollen, der Freiraum ausgestanzt wird. Auch danach kann wieder - wie schon beschrieben - die Umformung erfolgen.

Eine besonders vorteilhafte und kostengünstige Anwendung besteht darin, daß das jeweilige Leiterende 4 bei einem Flachbandkabel gemäß Figur 1 bzw. bei einem Flachbandkabel gemäß Figur 6 nach dem Unterteilen in Teilabschnitte 20 in eine U-bzw. Hohlkehlenform 6 gebracht wird, die dem Kontaktierungsbereich des Crimpkontaktes 17 entspricht. Nach dem Einlegen des umgeformten Leiterendes 4 bzw. des Teilabschnittes 20 wird dieser Bereich in den entsprechend geformten Kontaktierungsbereich des Crimpkontaktes 17 eingelegt und beide Teile zusammen umgeformt (gecrimpt). Dieser Crimpvorgang ist an sich bekannt und kann manuell oder automatisch erfolgen. Dieser Crimpvorgang hat den Vorteil, daß er gerade bei einer Serienfertigung automatisiert und damit kostengünstig ausgeführt werden kann. Ein weiterer Vorteil besteht darin, daß die Kontaktierungsfahnen des Crimpkontaktes das Leiterende nach dem Crimpen umschließen und somit eine mechanisch und elektrisch zuverlässige Verbindung entsteht, die zudem noch gasdicht ist. Damit werden wirksam Korrosionen im Kontaktierungsbereich vermieden.

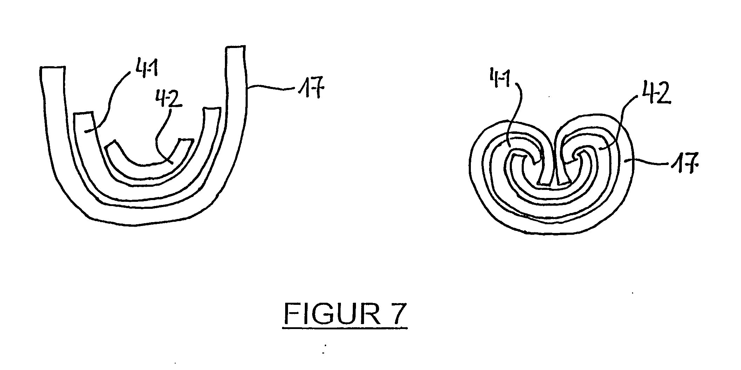

Figur 7 zeigt zwei verschieden breite Leiterenden, die miteinander vercrimpt werden. Allgemein wird bei diesem Ausführungsbeispiel die Idee verwirklicht, daß zumindest ein Leiterende 4, 41 eines elektrischen Leiters 2 des Flachbandkabels 1 mit einem Leiterende 4, 42 eines elektrischen Leiters 2 desselben Flachbandkabels 1 und/oder zumindest eines weiteren Flachbandkabels zusammen im Kontaktierungsbereich angeordnet sind. Dabei wird bei der Herstellung der Kontaktierung wie folgt vorgegangen: Zumindest zwei Leiterenden 41, 42, die zu einem Flachbandkabel 1 gehören, oder zumindest ein Leiterende 41, 42, welches jeweils zumindest zu einem weiteren Flachbandkabel gehört, werden freigelegt und im Kontaktierungsbereich umgeformt. Bei dem Ausführungsbeispiel bei der Figur 7 erfolgt die Umformung in eine U-Form oder auch in eine Hohlkehlenform. Dabei ist, wie auch schon bei den vorangegangen Ausführungsbeispielen, wichtig, daß die Leiterenden, die gleich oder unterschiedlich breit sein können, der Form im Kontaktierungsbereich des Kontaktpartners, bei Figur 7 der Crimpkontakt 17, angepaßt sind. Dies hat den Vorteil, daß sich die Form der Leiterenden 41, 42 im Kontaktierungsbereich des Crimpkontaktes 17 dessen Form anpaßt und eine größtmögliche Auflagefläche erzielt wird. Außerdem ist schon eine Lagepositionierung der Leiterenden 41, 42 untereinander und gleichzeitig zu dem Kontaktierungsbereich des Crimpkontaktes 17 gegeben. Nachdem die Leiterenden 41, 42 und der Crimpkontakt 17 zueinander positioniert worden sind (Figur 7, linke Hälfte) erfolgt in an sich bekannter Weise das Vercrimpen, welches in Figur 7, rechte Hälfte dargestellt ist. Durch diese Vercrimpung werden die Leiterenden 41, 42 sicher und dauerhaft an dem Crimpkontakt 17 befestigt. Eine weitere Ausführungsform dieser Ausgestaltung ist darin zu sehen, daß es sich bei dem hier dargestellten Crimpkontakt 17 nicht nur um einen Steckverbinder handeln muß, sondern grundsätzlich um einen Verbinder, der die beiden Leiterenden 41, 42 (oder auch mehr als zwei Leiterenden) miteinander verbindet. So wird auf einfache Art und Weise, dauerhaft und elektrisch zuverlässig eine Verbindung zwischen zumindest zwei Leitern ein und desselben Flachbandkabels oder wenigstens zweier Flachbandkabel untereinander gewährleistet. Dadurch besteht die besonders vorteilhafte Möglichkeit, mit elektrischen Leitern einer Flachbandleitung mehrere Verbraucher untereinander zu verbinden, wobei die geometrischen Abmessungen (vor allen Dingen Breite und Dicke des elektrischen Leiters) in Abhängigkeit von der zu übertragenden Stromstärke zwischen den einzelnen Verbrauchern gewählt werden kann. So kann beispielsweise einem Hauptverbraucher über ein breiteres und/oder dickeres Flachbandkabel der Strom zugeführt werden, indem dessen elektrischer Leiter über einen Crimpkontakt an dem Verbraucher angeschlossen ist. Von dieser Kontaktstelle kann ein weiteres Flachbandkabel mit einem dünneren und/oder schmaleren elektrischen Leiter gleichzeitig abgezweigt werden, welches beispielsweise zu einem Nebenverbraucher mit nicht so großer Stromaufnahme wie der Hauptverbraucher sie hat zugeführt werden.

Der Vollständigkeit halber sei noch darauf hingewiesen, daß die umgeformten Leiterenden 4 nach ihrer Umformung noch mit einer Oberflächenbehandlung (wie beispielsweise einer Beschichtung durch thermisches Metallspritzen) versehen werden können, um ein Bilden einer Oxidschicht zu vermeiden. Außerdem verbessert diese Beschichtung einen anschließenden Löt- oder Schweißprozess.

### Bezugszeichenliste:

- 1: Flachbandkabel
- 2: elektrischer Leiter
- 3: Isoliermantel
- 4: Leiterende
- 5: offene Rundform
- 6: Hohlkehlenform
- 7: gefaltete Form
- 8: geschlossene Rundform
- 9: Kontaktstelle
- 10: Leiterplatte
- 11: Kontaktstelle
- 12: Bauteil
- 13: Gehäuse
- 14: Oberteil
- 15: Unterteil
- 16: Federkontakt
- 17: Crimpkontakt
- 18: Federkontakt
- 19: Stiftkontakt
- 20: Teilabschnitt
- 21: Trennlinie
- 41: Leiterende
- 42: Leiterende

## Patentansprüche

1. Flachbandkabel (1) mit einem elektrischen Leiter (2) oder mehreren parallel zueinander verlaufenden elektrischen Leitern (2), deren Leiterenden (4) zwecks unlösbarer Kontaktierung mit einem Kontaktpartner freilegbar sind, das Leiterende (4) vor der Kontaktierung in eine der Form des Kontaktierungsbereiches des Kontaktpartners entsprechende Form umgeformt ist und anschließend unlösbar mit dem Kontaktpartner verbunden wird.

2. Flachbandkabel (1) nach Anspruch 1, **dadurch gekennzeichnet, daß** die Umformung für alle Leiterenden (4) des Flachbandkabels (1) gleich oder unterschiedlich ist.

3. Flachbandkabel (1) nach einem der vorhergehenden Ansprüche, **dadurch gekennzeichnet, daß** die umgeformten Leiterenden (4) abgewinkelt sind.

4. Flachbandkabel (1) nach einem der vorhergehenden Ansprüche, **dadurch gekennzeichnet, daß** die umgeformten Leiterenden (4) gewellt oder gezackt sind.

5. Flachbandkabel (1) nach einem der vorhergehenden Ansprüche, **dadurch gekennzeichnet, daß** der Kontaktpartner eine Kontaktstelle (9) einer Leiterplatte (10) ist, wobei das Leiterende (4) vor der Kontaktierung in eine Rundform (5, 8) umgeformt ist.

6. Flachbandkabel (1) nach einem der vorhergehenden Ansprüche, **dadurch gekennzeichnet, daß** die umgeformten Leiterenden (4) mit einer elektrisch leitfähigen Schicht beschichtbar sind.

7. Flachbandkabel (1) nach einem der vorhergehenden Ansprüche, **dadurch gekennzeichnet, daß** das Leiterende (4) in wenigstens zwei Teilabschnitte (20) unterteilbar ist und jeder Teilabschnitt (20) vor der Kontaktierung in die der Form des Kontaktierungsbereiches des Kontaktpartners entsprechende Form umgeformt wird.

8. Flachbandkabel (1) nach Anspruch 7, **dadurch gekennzeichnet, daß** die Unterteilung in Längsrichtung des Leiters (2) durch Auftrennen entlang einer Trennlinie (21) erfolgt.

9. Flachbandkabel (1) nach Anspruch 7 oder 8, **dadurch gekennzeichnet, daß** die Unterteilung derart erfolgt, daß zwischen den Teilabschnitten (20) ein Freiraum entsteht.

10. Flachbandkabel (1) nach einem der vorhergehenden Ansprüche, **dadurch gekennzeichnet, daß** das Leiterende (4) in eine Hohlkehlen- bzw. U-Form (6) ausgeformt und mit dem Kontaktierungsbereich eines Crimpkontaktes (17) verbunden wird.

11. Flachbandkabel (1) nach einem der vorhergehenden Ansprüche, **dadurch gekennzeichnet, daß** zumindest ein Leiterende (4, 41) eines elektrischen Leiters (2) des Flachbandkabels (1) mit einem Leiterende (4, 42) eines elektrischen Leiters (2) desselben Flachbandkabels (1) und/oder zumindest eines weiteren Flachbandkabels zusammen im Kontaktierungsbereich angeordnet ist.

12. Flachbandkabel (1) nach einem der vorhergehenden Ansprüche, **dadurch gekennzeichnet, daß** die Leiterenden (4, 41, 42) gleich oder unterschiedlich breit sind.

## Claims

1. Flat ribbon cable (1) having an electrical conductor (2) or a plurality of electrical conductors (2) extending parallel to one another, whose conductor ends (4) can be exposed for the purpose of making non-detachable contact with a contact partner, **characterized in that** the conductor end (4) is deformed prior to contact-making so as to form a shape which corresponds to the shape of the contact-making region of the contact partner and is then connected in a non-detachable fashion to the contact partner.

2. Flat ribbon cable (1) according to Claim 1, **characterized in that** the deformation is the same or is different for all of the conductor ends (4) of the flat ribbon cable (1).

3. Flat ribbon cable (1) according to one of the preceding claims, **characterized in that** the deformed conductor ends (4) are bent back.

4. Flat ribbon cable (1) according to one of the preceding claims, **characterized in that** the deformed conductor ends (4) are corrugated or serrated.

5. Flat ribbon cable (1) according to one of the preceding claims, **characterized in that** the contact partner is a contact point (9) on a printed circuit board (10), the conductor end (4) being deformed prior to contact-making so as to form a round shape (5, 8).

6. Flat ribbon cable (1) according to one of the preceding claims, **characterized in that** the deformed conductor ends (4) can be coated with an electrically conductive layer.

7. Flat ribbon cable (1) according to one of the preceding claims, **characterized in that** the conductor end (4) can be divided into at least two subsections (20), and each subsection (20) is deformed prior to contact-making so as to form a shape which corresponds to the shape of the contact-making region of the contact partner.

8. Flat ribbon cable (1) according to Claim 7, **characterized in that** the subdivision takes place in the longitudinal direction of the conductor (2) by means of a separation along a separation line (21).

9. Flat ribbon cable (1) according to Claim 7 or 8, **characterized in that** the subdivision takes place such that a free space is produced between the subsections (20).

10. Flat ribbon cable (1) according to one of the preceding claims, **characterized in that** the conductor end (4) is shaped so as to form a flute shape or a U shape (6) and is connected to the contact-making region of a crimp contact (17).

11. Flat ribbon cable (1) according to one of the preceding claims, **characterized in that** at least one conductor end (4, 41) of an electrical conductor (2) of the flat ribbon cable (1) is arranged in the contact-making region together with one conductor end (4, 42) of an electrical conductor (2) of the same flat ribbon cable (1) and/or at least one further flat ribbon cable.

12. Flat ribbon cable (1) according to one of the preceding claims, **characterized in that** the conductor ends (4, 41, 42) have the same or different widths.

## Revendications

1. Câble en nappe (1) comprenant un conducteur électrique (2) ou plusieurs conducteurs électriques (2) qui sont parallèles les uns aux autres dont les extrémités de conducteur (4) peuvent être dégagées en vue d'établir un contact inamovible avec un partenaire de contact, l'extrémité de conducteur (4) est façonnée avant l'établissement du contact dans une forme correspondant à la forme de la zone d'établissement du contact du partenaire de contact et elle est ensuite reliée de manière inamovible avec le partenaire de contact.

2. Câble en nappe (1) selon la revendication 1, **caractérisé en ce que** le façonnage est égal ou différent pour toutes les extrémités de conducteur (4) du câble en nappe (1).

3. Câble en nappe (1) selon l'une des revendications précédentes, **caractérisé en ce que** les extrémités de conducteur (4) façonnées sont coudées.

4. Câble en nappe (1) selon l'une des revendications précédentes, **caractérisé en ce que** les extrémités de conducteur (4) façonnées sont ondulées ou dentelées.

5. Câble en nappe (1) selon l'une des revendications précédentes, **caractérisé en ce que** le partenaire de contact est un point de contact d'un circuit imprimé (10), l'extrémité de conducteur (4) étant façonnée en une forme ronde (5, 8) avant l'établissement du contact.

6. Câble en nappe (1) selon l'une des revendications précédentes, **caractérisé en ce que** les extrémités de conducteur (4) façonnées peuvent être enduites d'une couche conductrice d'électricité.

7. Câble en nappe (1) selon l'une des revendications précédentes, **caractérisé en ce que** l'extrémité de conducteur (4) peut être divisée en au moins deux sections partielles (20) et chaque section partielle (20) est façonnée avant l'établissement du contact dans une forme correspondant à la forme de la zone d'établissement du contact du partenaire de contact.

8. Câble en nappe (1) selon la revendication 7, **caractérisé en ce que** la division est effectuée dans le sens longitudinal du conducteur (2) par une séparation le long d'une ligne de séparation (21).

9. Câble en nappe (1) selon la revendication 7 ou 8, **caractérisé en ce que** la division est effectuée de manière à obtenir un espace libre entre les sections partielles (20).

10. Câble en nappe (1) selon l'une des revendications précédentes, **caractérisé en ce que** l'extrémité de conducteur (4) est façonnée en forme de gorge ou de U (6) et elle est reliée avec la zone d'établissement du contact d'un contact à sertir (17).

11. Câble en nappe (1) selon l'une des revendications précédentes, **caractérisé en ce qu'**au moins une extrémité de conducteur (4, 41) d'un conducteur électrique (2) du câble en nappe (1) est disposée dans la zone d'établissement du contact conjointement avec une extrémité de conducteur (4, 42) d'un conducteur électrique (2) du même câble en nappe (1) et/ou d'au moins un câble en nappe supplémentaire.

12. Câble en nappe (1) selon l'une des revendications précédentes, **caractérisé en ce que** les extrémités de conducteur (4, 41, 42) sont de largeurs identiques ou différentes.
